(19) Europäisches Patentamt
European Patent Office
Office européen des brevets

(11) EP 2 631 663 A1

(12) EUROPÄISCHE PATENTANMELDUNG

(43) Veröffentlichungstag:
28.08.2013 Patentblatt 2013/35

(51) Int Cl.:
$G01R\ 31/36$ (2006.01)

(21) Anmeldenummer: 12156563.4

(22) Anmeldetag: 22.02.2012

(84) Benannte Vertragsstaaten:
AL AT BE BG CH CY CZ DE DK EE ES FI FR GB GR HR HU IE IS IT LI LT LU LV MC MK MT NL NO PL PT RO RS SE SI SK SM TR
Benannte Erstreckungsstaaten:
BA ME

(71) Anmelder: Siemens Aktiengesellschaft
80333 München (DE)

(72) Erfinder: Bierhoff, Thomas, Dr.
33106 Paderborn (DE)

(54) Verfahren zur kontinuierlichen Überwachung einer Batteriealterung

(57) Die Erfindung betrifft ein Verfahren zur kontinuierlichen Überwachung einer Batteriealterung, wobei die Batteriealterung auf Basis eines Batteriestroms ($i_B(t)$) quantitativ beschrieben wird.

FIG 3

EP 2 631 663 A1

**Beschreibung**

Die Erfindung betrifft ein Verfahren zur kontinuierlichen Überwachung einer Alterung einer Batterie (Batteriealterung) in einem Echtzeitbetrieb mittels einer Alterungsmetrik. Sie bezieht sich weiter auf eine Vorrichtung zur Durchführung des Verfahrens und auf weitergehende Verwendungen des Verfahrens.

Sekundärbatterien (z.B. Li-Ion Technologie) in Elektrofahrzeugen oder Energiespeichersystemen stellen einen der Hauptkostentreiber im Bereich der Elektromobilität oder sogenannten Smart Meter Applikationen dar, da sie in der Anschaffung sehr teuer sind und aufgrund üblicher Alterungsprozesse nach einer mittleren Einsatzzeit wieder ausgetauscht werden müssen.

Durch die alterungsbedingte Notwendigkeit zum Austausch einer Batterie entstehen zusätzlich hohe Betriebskosten. Der Alterungsprozess ergibt sich aufgrund wiederkehrender Lade- und Entladevorgänge im Betrieb der Batterie, die eine stetige Reduktion ihrer Ladungskapazität verursachen. Der Alterungsprozess der Batterie wird vornehmlich durch den jeweiligen Lade- oder Entladestrom verursacht und darüber hinaus durch die Betriebstemperatur beeinflusst. Bei Erreichen einer definierten unteren Ladekapazitätsschwelle müssen gealterte Batterien ausgetauscht werden.

Um den Zeitpunkt für einen notwendigen Austausch einer Batterie oder einer Gruppe von Batterien möglichst präzise vorhersagen zu können, wird ein Verfahren sowie eine Metrik benötigt, die den Alterungsprozess der Batterie (n) in Abhängigkeit des Batteriestroms quantitativ beschreibt.

Aus der EP 1 450 173 A ist ein Verfahren zur Ermittlung der Alterung einer Batterie bekannt. Dort wird eine definierte Metrik zur zyklischen Berechnung der Batteriealterung vorgeschlagen, die allerdings jeweils nur nach Abschluss eines Teillade- oder Teilentladezyklus angewendet werden kann. Eine kontinuierliche Ermittlung der Batteriealterung auch innerhalb der Teilladezyklen ist dementsprechend nicht möglich. Darüber hinaus verwendet das Verfahren Kennlinien / Wertetabellen, die den Zusammenhang zwischen einer Entladetiefe und einem Alterungskennwert darstellen. Eine jeweilige Kennlinie oder Wertetabelle muss allerdings für jeden Batterietyp sehr aufwendig durch eine Vielzahl von Messreihen (pro Entladetiefe eine Messreihe) im Vorfeld ermittelt werden, damit das Verfahren angewendet werden kann.

Eine Aufgabe der Erfindung besteht entsprechend darin, ein Verfahren zur Ermittlung der Batteriealterung anzugeben, das zu grundsätzlich beliebigen Zeitpunkten, zumindest jedoch auch innerhalb von Teilladezyklen oder Teilentladezyklen, die Batteriealterung beschreibt.

Diese Aufgabe wird erfindungsgemäß mit einem Verfahren mit den Merkmalen des Anspruchs 1 gelöst. Dazu ist bei einem Verfahren zur kontinuierlichen Überwachung einer Batteriealterung vorgesehen, dass die Batteriealterung auf Basis eines jeweiligen Batteriestroms $i_B$ (t) quantitativ beschrieben wird.

Die Erfindung geht dabei von der Erkenntnis aus, dass ein sehr einfaches Verfahren zur Bestimmung der Batteriealterung von einer Anzahl herstellerseitig angegebener Vollladezyklen ausgehen kann. Dabei definiert der Hersteller einer Batterie, wie viele Vollladezyklen die Batterie durchführen kann, bis sie eine vorgegebene Leistungsschwelle (z.B. 80% der initialen Batteriekapazität) unterschreitet. Als Vollladezyklus wird ein kombinierter Lade- und Entladezyklus definiert, bei dem zunächst eine volle Batterie vollständig entladen und danach wieder vollständig geladen wird. Setzt man die Zahl der durchlaufenen Batterieladezyklen $N_c$ ins Verhältnis zu den herstellerspezifischen Vollladezyklen $N_{fc}$, so kann man die Batteriealterung beschreiben:

$$A = {N_c}/{N_{fc}} \in [0,1]$$

$$(1)$$

Der Quotient A kann demnach die Werte 0 und 1 annehmen und A = 0 bedeutet eine neue oder zumindest noch ausreichend verwendbare Batterie, während bei A = 1 ein Austausch der Batterie erforderlich ist.

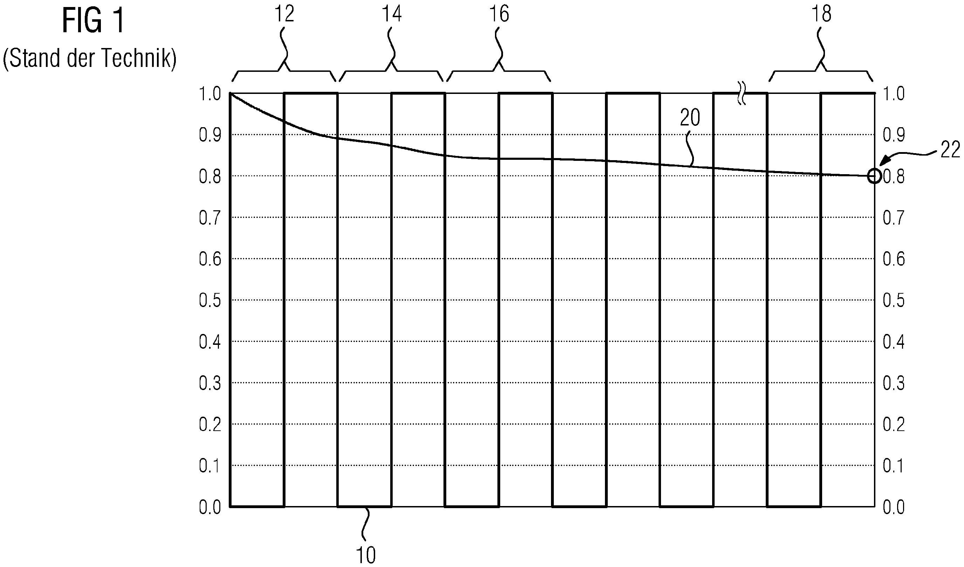

Die Darstellung in FIG 1 stellt eine Abfolge von Entladezyklen und anschließenden Ladezyklen zur jeweils vollständigen Entladung und anschließenden vollständigen Ladung (Vollladezyklus) dar. Eine rechteckig gezeichnete erste Kurve 10 stellt dabei über der auf der Abszisse aufgetragenen Zeit den jeweiligen Ladezustand der Batterie (State-of-Charge / SoC) dar. Auf der Ordinate ist dafür ein von 0.0 bis 1.0 normierter Ladezustand aufgetragen. Eingezeichnet sind des Weiteren ein erster Ladezyklus 12, ein zweiter Ladezyklus 14, ein dritter Ladezyklus 16 und schließlich ein n-ter Ladezyklus 18, also zum Beispiel ein fünfhundertster Ladezyklus 18. Schließlich ist als zweite Kurve 20 die resultierende Batteriealterung (State-of-Health / SoH) eingezeichnet. Für die mit dem Pfeil gekennzeichnete Stelle 22 wird angenommen, dass ein Batterieaustausch erforderlich ist.

Ein gravierender Nachteil dieses Ansatzes ist allerdings die Tatsache, dass in der Realität anstelle von Vollladezyklen eher Teilladezyklen auftreten. Diese verursachen eine geringere Batteriealterung im Vergleich zu den Vollladezyklen, so dass eine Bestimmung der Batteriealterung mit der oben eingeführten Gleichung 1 sehr ungenau und konservativ ist.

Eine Verbesserung stellt das vom Fraunhofer-Institut für System- und Innovationsforschung ISI entwickelte und in "Working Paper Sustainability and Innovation No. S4/2010, Seite 12-13" publizierte Modell dar. Bei diesem Modell werden anstelle von Vollladezyklen nur symmetrische Teilladezyklen betrachtet. Das resultierende Verfahren definiert einen symmetrischen Teilladezyklus als einen kombinierter Lade- und Entladezyklus, bei dem eine volle Batterie anteilig entladen und anschließend wieder um diesen Anteil vollständig aufgeladen wird. Die Anzahl $N_{pc}$ dieser Teilladezyklen ist größer als die Anzahl der Vollladezyklen $N_{fc}$ und wird über die vom Fraunhofer Institut vorgeschlagene und nachfolgend aufgeführte Metrik beschrieben, in der $D_{od}$ die jeweilige Entladetiefe bezeichnet:

$$N_{pc} = N_{fc} \cdot D_{od}^{-\alpha} = {N_{Fc}}/{D_{od}^{\alpha}} \gg N_{fc} \quad \text{mit } \alpha > 0 \tag{2}$$

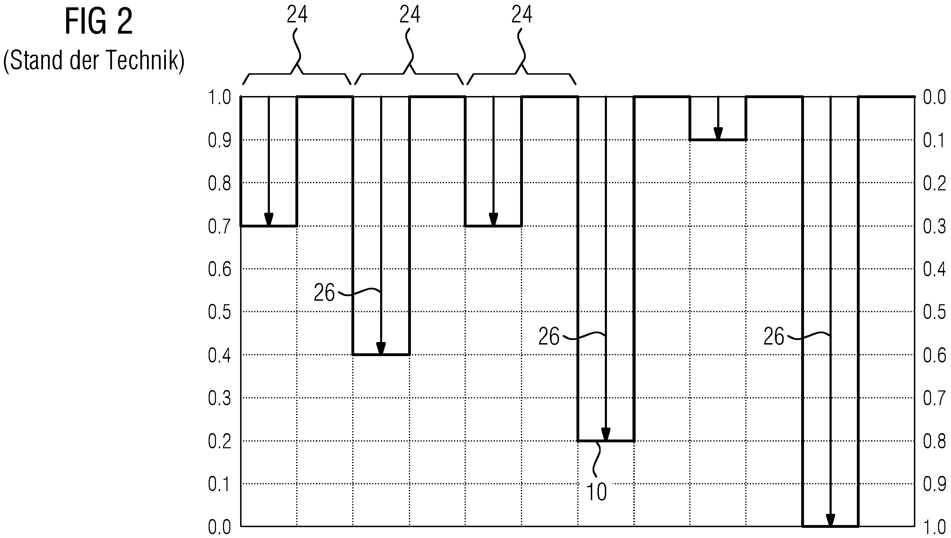

Auch dieser Ansatz ist graphisch veranschaulicht und zwar in FIG 2. Die Achsen des dargestellten Koordinatensystems entsprechen den Achsen des Koordinatensystems in FIG 1. Eine erste Kurve 10 stellt erneut den über der Zeit aufgetragenen Ladezustand der Batterie (State-of-Charge / SoC) dar. Die einzelnen Teilladezyklen 24 sind symmetrisch, das heißt, dass auf eine teilweise Entladung 26 immer eine gleich große Ladung folgt, so dass am Ende eines jeden Teilladezyklus 24 die Batterie jeweils vollständig geladen ist. Die Entladung 26 ist dabei durch abwärts gerichtete Pfeile veranschaulicht, deren Länge ein Maß für die jeweilige Entladung $D_{od}$ ist.

Ein Nachteil dieses Ansatzes ist die Beschränkung auf symmetrische Teilladezyklen, bei denen mit der Entladung und der nachfolgenden Ladung der Batterie betragsmäßig genau derjenige Energieanteil wieder zugeführt wird, der zuvor während der Entladung entnommen wurde. In der Realität ist dies oftmals nicht der Fall, da eine Ladung eine vorhergehende Entladung der Batterie nicht notwendigerweise exakt kompensiert. Auch kann eine Alterungsmetrik nicht direkt aus den Teilladezyklen abgeleitet werden, da diese sich für jede Entladetiefe $D_{od}$ unterschiedlich gestaltet.

Der in der EP 1 450 173 A2 vorgestellte Ansatz versucht dem Rechnung zu tragen, indem ein Teilzyklus in einen Teilladezyklus und einen Teilentladezyklus aufgeteilt wird. Damit können auch asymmetrische Teilzyklen beschrieben werden, bei denen eine Entladung und eine darauf folgende Ladung der Batterie unterschiedlich stark ausfallen können. Grundlage der Alterungsberechnung sind Alterungskennwerte $A_{ki}$, die für eine definierte Entladetiefe $D_{od}$ der Batterie zu bestimmen sind.

Ein Zusammenhang zwischen einem Alterungskennwert $A_{ki}$ und einer Entladetiefe $D_{od}$ wird durch eine zu bestimmende, batterieabhängige Kennlinie / Wertetabelle definiert. Wie eine solche Kennlinie / Wertetabelle im Einzelnen zu bestimmen ist, wird in der EP 1 450 173 A2 nicht näher erläutert.

Die Batteriealterung soll demnach wie folgt ermittelt werden

$$A = \sum_{i=0}^{N_{pc}-1} n_i \cdot A_{ki}(D_{od,i}), \tag{3}$$

wobei $A_{ki}$ den Alterungskennwert der Batterie für eine definierte Entladetiefe $D_{od,i}$, $D_{od,i}$ die aufgetretene Entladetiefe im i-ten Zyklus, $n_i$ die Anzahl der Teilladezyklen und Teilentladezyklen mit einer konstanten Entladetiefe und $N_{pc}$ die Anzahl der Teilladezyklen und Teilentladezyklen mit unterschiedlicher Entladetiefe darstellen. Dabei ist zu beachten, dass die so ermittelbare Batteriealterung A (Gleichung 3) eine absolute Kennzahl darstellt, die nicht direkt mit der relativen Batteriealterung gemäß Gleichung 1 verglichen werden kann.

Die wesentlichen Nachteile dieses Ansatzes sind, dass die Alterung A der Batterie nur nach einem Teilladezyklus oder Teilentladezyklus durch Auswerten einer vorgegebenen Wertetabelle oder Kennlinie zeitdiskret ausgewertet werden kann. Eine Auswertung der Alterung zu beliebigen Zeitpunkten auch innerhalb der Lade- und Entladezyklen ist somit nicht möglich. Außerdem muss für jeden Batterietyp der Zusammenhang zwischen der Entladetiefe $D_{od}$ und der Alterungskennzahl $A_{ki}$ (zum Beispiel mittels Messreihen für jede zu berücksichtigende Entladetiefe $D_{od}$) im Vorfeld aufwendig ermittelt werden. Dies führt weiterhin zu Diskretisierungsfehlern, da nicht beliebig viele Messreihen für die Kennlinienbestimmung sinnvollerweise durchgeführt werden können und zumindest die Wertetabelle oder Kennlinie nicht beliebig detailliert für eine Vorrichtung zur Bestimmung der Batteriealterung vorgehalten werden kann.

Der Vorteil der Erfindung besteht ausgehend von diesen Nachteilen des Standes der Technik damit darin, dass ein Verfahren angegeben werden kann, mit dessen Hilfe eine relative Alterung der Batterie auf Basis des Batteriestroms $i_B(t)$ zu jedem beliebigen Zeitpunkt, insbesondere auch innerhalb von Teilladezyklen oder Teilentladezyklen, bestimmt werden kann.

Anstatt die Batteriealterung mit Hilfe einer Wertetabelle und einer zeitdiskreten Metrik - wie oben bei der Gleichung 3 - auszuwerten, wird eine unten in Gleichung 4 dargestellte Metrik vorgeschlagen, die auf Basis des Batteriestroms $i_B$ (t) kontinuierlich die relative Batteriealterung bestimmen kann.

$$A(t) = \frac{1}{N_{fc}(I_{BO})} \cdot \left[ \frac{1}{2 \cdot C_B} \int_{t_0}^{t} \eta(i_B) \cdot |i_B(\tau)| d\tau \right]^{\alpha} + A(t_0) \in [0,..,1] \quad mit\ A(t=0) = 0$$

$$(4)$$

Dabei sind A(t) eine Alterungszahl der Batterie zum Zeitpunkt t, $N_{fc}$ eine vom jeweiligen Batteriehersteller spezifizierte Anzahl von Vollladezyklen der Batterie bei konstantem Lade- und Entladestrom $I_{BO}$, $I_{BO}$ der vom Batteriehersteller spezifizierte Batteriestrom, bei dem $N_{fc}$ Vollladezyklen garantiert werden können, $i_B$ (t) der elektrische Batteriestrom, $C_B$ die Kapazität der Batterie in [Ah], $\alpha$ ein Anpassungsparameter ($\alpha > 1$) für unterschiedliche Batterietechnologien und $\eta$ ($i_B$) eine Funktion zur Berücksichtigung des Einflusses des Batteriestroms $i_B$ (t) auf die Batteriealterung (falls $i_B$ (t) = $I_{BO} \rightarrow \eta$=1).

Die Alterungszahl A(t) kann die Werte 0 und 1 annehmen und A (t) = 0 bedeutet eine neue oder zumindest noch ausreichend verwendbare Batterie, während bei A (t) = 1 ein Austausch der Batterie erforderlich ist. Auf die Alterungszahl A(t) wird im Folgenden auch als Batteriealterung A(t) Bezug genommen.

Die Gleichung 4 ist die oben im Zusammenhang mit der Kurzdarstellung der hier vorgeschlagenen Lösung der eingangs formulierten Aufgabe genannte, quantitative Beschreibung der Batteriealterung auf Basis eines jeweiligen Batteriestroms $i_B$ (t).

Da der Batteriestrom $i_B$ (t) innerhalb einer sogenannten BMU (Battery Management Unit / Batteriemanagement-Einheit) einer Batterie kontinuierlich erfasst werden kann, kann mit Hilfe dieser Metrik die Batteriealterung im Betrieb zu jedem beliebigen Zeitpunkt ausgewertet werden.

Vorteilhafte Ausgestaltungen der Erfindung sind Gegenstand der Unteransprüche. Dabei verwendete Rückbeziehungen weisen auf die weitere Ausbildung des Gegenstandes des Hauptanspruches durch die Merkmale des jeweiligen Unteranspruches hin. Sie sind nicht als ein Verzicht auf die Erzielung eines selbständigen, gegenständlichen Schutzes für die Merkmalskombinationen der rückbezogenen Unteransprüche zu verstehen. Des Weiteren ist im Hinblick auf eine Auslegung der Ansprüche bei einer näheren Konkretisierung eines Merkmals in einem nachgeordneten Anspruch davon auszugehen, dass eine derartige Beschränkung in den jeweils vorangehenden Ansprüchen nicht vorhanden ist.

Vorteilhaft gibt die gemäß der Gleichung 4 jeweils ermittelte Alterungszahl A(t) direkt Aufschluss über die Batteriealterung und/oder einen eventuell notwendigen Austausch der Batterie.

Bei einer Ausführungsform des Verfahrens wird gemäß der Gleichung 4 zur Beschreibung der Batteriealterung eine von einem jeweiligen Ermittlungszeitpunkt t abhängige Alterungszahl A(t) ermittelt.

Bei einer weiteren Ausführungsform des Verfahrens fließt in die Ermittlung der Batteriealterung gemäß Gleichung 4 eine vorgegebene oder vorgebbare Funktion $\eta$ ($i_B$) zur Berücksichtigung des Einflusses der Stromstärke $i_B$ (t) auf die Batteriealterung ein.

Das Verfahren wie hier und nachfolgend beschrieben eignet sich besonders für die Verwendung im Zusammenhang mit einer Einheit oder Einrichtung zum Batteriemanagement (Batteriemanagement-Einheit). Dabei wird das Verfahren zur Ermittlung der Batteriealterung, insbesondere die insoweit vorgeschlagene Gleichung 4, in Software oder in Soft- und Hardware oder Firmware implementiert. Die Erfindung ist damit einerseits zum Beispiel auch ein Computerprogramm mit durch einen Computer ausführbaren Programmcodeanweisungen und andererseits ein Speichermedium mit einem derartigen Computerprogramm sowie schließlich auch eine solche Batteriemanagement-Einheit mit einer Verarbeitungseinheit in Form von oder nach Art eines Mikroprozessors und einem Speicher, in den als Mittel zur Durchführung des Verfahrens und seiner Ausgestaltungen ein solches Computerprogramm geladen oder ladbar ist. Bei einer Verarbeitungseinheit in Form eines sogenannten ASICs oder dergleichen, ist die Implementation des Verfahrens Teil des ASICs; Verarbeitungseinheit und Speicher fallen also gleichsam zusammen.

Eine solche Batteriemanagement-Einheit und ein von dieser als Ergebnis des Verfahrens ausgeführtes Batteriemanagement kommt besonders zum Einsatz in oder im Zusammenhang mit einem Fahrerassistenzsystem für batteriegetriebene Fahrzeuge oder sogenannte Hybridfahrzeuge mit einem Elektromotor und einem Verbrennungsmotor in Betracht, wobei die Batteriemanagement-Einheit an das jeweilige Fahrerassistenzsystem kontinuierlich oder zu vorgegebenen oder vorgebbaren Zeitpunkten Informationen zur Batteriealterung übermittelt. Das Fahrerassistenzsystem ist somit über den Status der Batteriealterung informiert und kann diese Information zum Beispiel in eine Anzeige für den jeweiligen Fahrzeugführer umsetzen. Eine solche Anzeige kann kontinuierlich den jeweiligen Status der Batteriealterung abbilden oder alternativ erst dann aktiviert werden, wenn hinsichtlich der Batteriealterung ein vorgegebener oder vorgebbarer kritischer Wert erreicht ist.

Bei einem Fahrerassistenzsystem, das anhand der zur Batteriealterung erhaltenen Informationen einem Fahrzeugführer die jeweilige Batteriealterung anzeigt, kommt als besondere Ausführungsform in Betracht, dass eine solche Anzeige zusammen mit Hinweisen im Hinblick auf einen Zusammenhang einer jeweiligen Fahrweise und einer resultierenden Batteriealterung und/oder mit Hinweisen im Hinblick auf eine batterieschonende Fahrweise erfolgt.

Der Vorteil der Erfindung und ihrer Ausgestaltungen besteht damit insbesondere in der Zurückführung der Batteriealterung auf den Batteriestrom, der für eine Alterungsmetrik kontinuierlich ausgewertet werden kann. Damit werden Diskretisierungsfehler vermieden, wie sie z. B. bei Verfahren auftreten, die auf Wertetabellen oder Kennlinien basieren. Auch Assistenzsysteme, zum Beispiel für sogenannte Smart Meter Applikationen, benötigen eine kontinuierliche Überwachung der Batteriealterung, um gezielt den Einsatz von Elektromaschinen hinsichtlich einer möglichst geringen Batteriealterung auszubalancieren.

Nachfolgend wird ein Ausführungsbeispiel der Erfindung anhand der Zeichnung näher erläutert. Einander entsprechende Gegenstände oder Elemente sind in allen Figuren mit den gleichen Bezugszeichen versehen.

Das oder jedes Ausführungsbeispiel ist nicht als Einschränkung der Erfindung zu verstehen. Vielmehr sind im Rahmen der vorliegenden Offenbarung Abänderungen und Modifikationen möglich, die zum Beispiel durch Kombination oder Abwandlung von einzelnen in Verbindung mit den im allgemeinen oder speziellen Beschreibungsteil beschriebenen sowie in den Ansprüchen und/oder der Zeichnung enthaltenen Merkmalen bzw. Elementen oder Verfahrensschritten für den Fachmann im Hinblick auf die Lösung der Aufgabe entnehmbar sind und durch kombinierbare Merkmale zu einem neuen Gegenstand oder zu neuen Verfahrensschritten bzw. Verfahrensschrittfolgen führen.

Es zeigen

FIG 1     eine Darstellung von Entladezyklen und Ladezyklen, bei denen eine Batterie jeweils vollständig entladen und anschließend wieder vollständig geladen wird (Vollladezyklus),

FIG 2     eine Darstellung einer Abfolge von symmetrischen Teilentladezyklen und anschließenden Teilladezyklen, bei denen eine Batterie jeweils teilweise entladen und anschließend wieder auf einen Vollladezustand aufgeladen wird,

FIG 3     eine beispielhafte, aber grundsätzlich realistische Darstellung von Entladevorgängen und Ladevorgängen einer Batterie,

FIG 4     eine Gegenüberstellung eines im Stand der Technik bekannten Verfahrens zur Ermittlung einer Batteriealterung und des hier vorgeschlagenen Verfahrens zur Ermittlung einer Batteriealterung in Form schematisch vereinfachter Flussdiagramme,

FIG 5     ein Kraftfahrzeug mit einer Batterie und einer Batteriemanagement-Einheit als mögliche Implementation des hier vorgestellten Verfahrens sowie

FIG 6     die Batteriemanagement-Einheit und ein Fahrerassistenzsystem als ein Beispiel für eine der Batteriemanagement-Einheit nachfolgende Funktionseinheit mit weiteren Details.

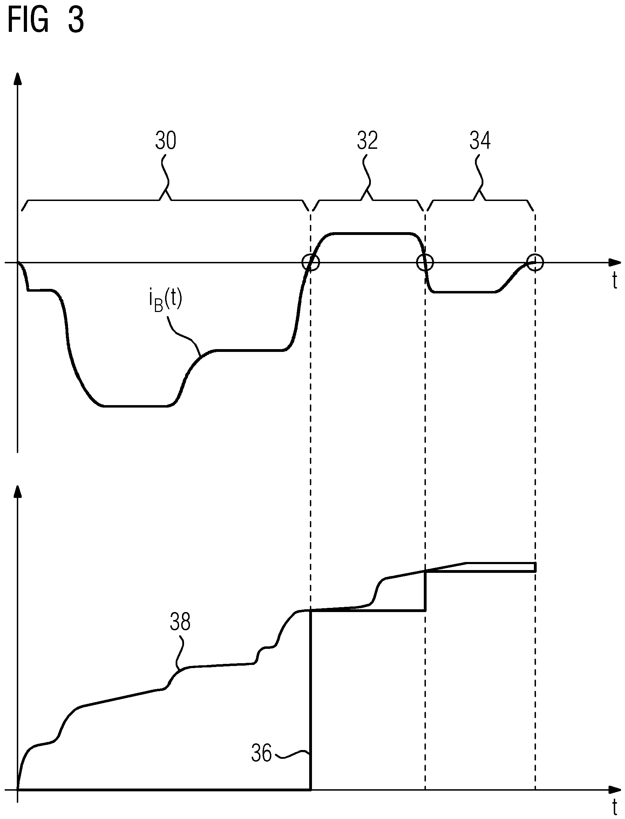

Ausgehend von den eingangs bereits im Zusammenhang mit einer Diskussion des Standes der Technik erörterten Darstellungen zeigt FIG 3 eine beispielhafte, aber grundsätzlich realistische Darstellung von Entladevorgängen und Ladevorgängen einer Batterie, wie sie sich zum Beispiel bei einer Verwendung einer solchen Batterie in einem Elektrofahrzeug oder einem Hybridfahrzeug ergibt.

In den beiden von FIG 3 umfassten Darstellungen ist auf der Abszisse jeweils die Zeit t aufgetragen. In der oberen Darstellung ist ein Verlauf eines Batteriestroms $i_B$ (t) in Ampere gezeigt. Solange der Batteriestrom $i_B$ (t) unterhalb der Abszisse, also im negativen Bereich, verläuft, findet eine Entladung der Batterie statt. Soweit der Batteriestrom $i_B$ (t) oberhalb der Abszisse, also im positiven Bereich, verläuft, wird die Batterie geladen. Der Verlauf des Batteriestroms $i_B$ (t) kann also in einen Entladeteilzyklus 30, einen Ladeteilzyklus 32 und einen weiteren Entladeteilzyklus 34 unterteilt werden, im Folgenden einzeln und zusammen als Teilzyklus bzw. Teilzyklen bezeichnet.

In der unteren Darstellung von FIG 3 ist eine ermittelte Batteriealterung A(t) dargestellt. Ein erster Graph 36 stellt dabei für Vergleichszwecke eine nach dem in der EP 1 450 173 A beschriebenen Ansatz (Gleichung 3) ermittelte Batteriealterung dar. Es fällt auf, dass die Batteriealterung jeweils nur beim Übergang von einem Lade- oder Entladezyklus zum nachfolgenden Entlade- bzw. Ladezyklus bestimmt werden kann, und dass innerhalb solcher Teilzyklen 30, 32, 34 weiterhin vom zuletzt ermittelten Wert für die Batteriealterung ausgegangen werden muss.

Demgegenüber ist ein zweiter Graph 38 eine Darstellung einer gemäß der Gleichung 4 ermittelten Batteriealterung A(t) in Abhängigkeit von dem in der oberen Darstellung in FIG 3 gezeigten Verlauf des Batteriestroms $i_B$ (t). Es ist ohne Weiteres erkennbar, dass der hier vorgeschlagene Ansatz zur Ermittlung der Batteriealterung eine kontinuierliche oder, bei einer üblichen Abtastung des Batteriestroms $i_B$ (t), zumindest eine quasi-kontinuierliche und damit insgesamt besser verwendbare und belastbarere Aussage hinsichtlich der Batteriealterung liefert.

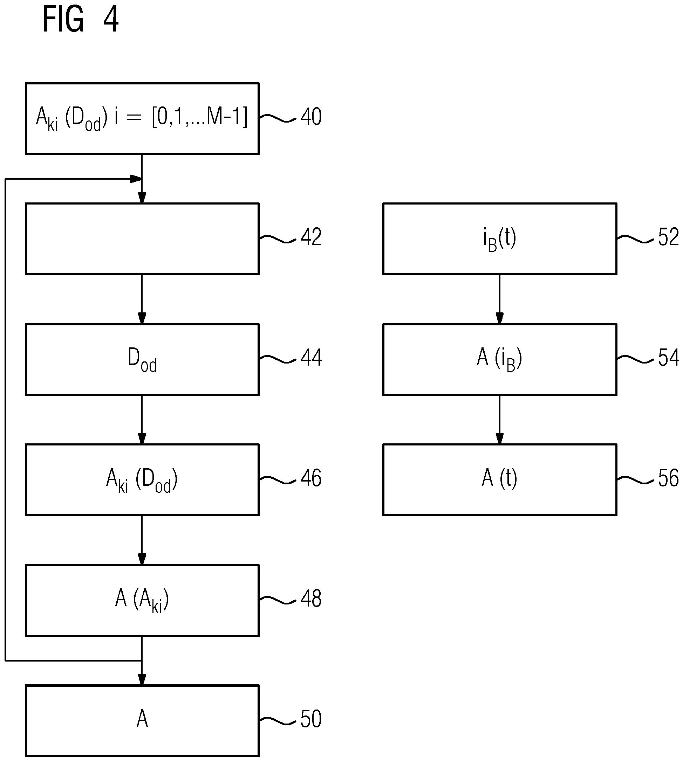

FIG 4 zeigt eine graphische Gegenüberstellung des Ansatzes gemäß der EP 1 450 173 A und des hier vorgestellten Ansatzes. Der Ansatz gemäß der EP 1 450 173 A ist dabei auf der linken Seite gezeigt. Dabei werden in einem ersten Schritt 40 die bei diesem Ansatz benötigten Kennlinien oder Wertetabellen $A_{ki}$ ($D_{od}$) i = [0, 1, ... M-1] bestimmt. Ein nachfolgender zweiter Schritt 42 ist für die Identifikation eines Teilzyklus erforderlich, denn nur an den Grenzen solcher Teilzyklen (FIG 3: 30, 32, 34) ist bei diesem Ansatz die Ermittlung der Batteriealterung möglich. In einem weiteren, dritten Schritt 44 wird die Entladetiefe $D_{od}$ im jeweiligen Teilzyklus bestimmt. Damit kann in einem nochmals weiteren, vierten Schritt 46 die Auswertung der im ersten Schritt 40 ermittelten Kennlinie / Wertetabelle erfolgen und ein Alterungskennwert $A_{ki}$ in Abhängigkeit von der ermittelten Entladetiefe $D_{od}$ bestimmt werden: $A_{ki}$ ($D_{od}$). Mit diesem Alterungskennwert $A_{ki}$ kann schließlich in einem fünften Schritt 48 die Anwendung der Metrik gemäß Gleichung 3 erfolgen und die Batteriealterung A in Abhängigkeit vom Alterungskennwert $A_{ki}$ ermittelt werden: A ($A_{ki}$).

Nachdem jeder Alterungskennwert $A_{ki}$ zu einem Teilzyklus gehört, ist die so ermittelte Batteriealterung A in gewisser Weise auch eine zeitabhängige Darstellung der Batteriealterung, ohne jedoch wirklich eine kontinuierliche Darstellung der Batteriealterung zu erlauben. Solange kein abgeschlossener Teilzyklus identifiziert ist, werden der zweite, dritte, vierte und fünfte Schritt 42-48 fortlaufend ausgeführt. Bei Identifikation eines Teilzyklus steht am Ende des Verfahrens eine Aussage hinsichtlich der Alterung A der Batterie am Ende des soeben identifizierten Teilzyklus (sechster Schritt 50).

Demgegenüber ist das hier vorgeschlagene Verfahren nicht nur einfacher, sondern liefert auch kontinuierliche oder quasi-kontinuierliche Werte für die Alterung A(t) der Batterie und zwar unabhängig von Teilzyklen oder Übergängen von einem Teilzyklus zu einem nachfolgenden Teilzyklus.

Danach umfasst das Verfahren (FIG 4, rechte Seite) in der dargestellten Abstraktion nur drei Schritte, nämlich einen ersten, zweiten und dritten Schritt 52, 54, 56. Im ersten Schritt 52 erfolgt eine kontinuierliche oder quasi-kontinuierliche Messung des Batteriestroms $i_B$ (t). Im zweiten Schritt 54 erfolgt für den jeweils gemessenen Batteriestrom $i_B$ (t) eine Auswertung der Metrik gemäß Gleichung 4: A ($i_B$). Im dritten Schritt 56 ergibt sich eine Alterung A(t) der jeweiligen Batterie zu jedem beliebigen Zeitpunkt t.

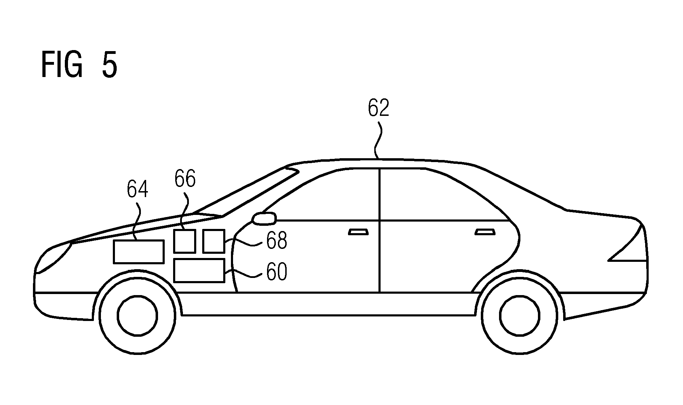

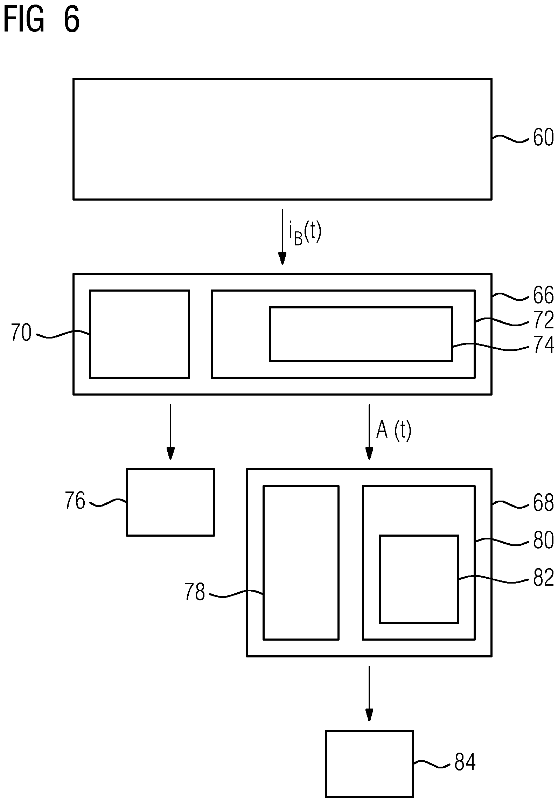

Das hier vorgeschlagene Verfahren eignet sich speziell für die Bestimmung der Alterung A(t) einer Batterie 60, wie sie in an sich bekannter Art zum Beispiel in einem Elektro- oder Hybridfahrzeug 62 zum Antrieb eines Elektromotors 64 oder sonstiger Verbraucher (nicht dargestellt) vorgesehen ist (FIG 5). Zur Anwendung des Verfahrens ist eine Batteriemanagement-Einheit 66, ggf. eine Batteriemanagement-Einheit 66 in Kombination mit einer nachfolgenden Einheit, zum Beispiel einem Fahrerassistenzsystem 68, vorgesehen, die in FIG 6 mit weiteren Details dargestellt ist.

FIG 6 zeigt dementsprechend in schematisch vereinfachter Darstellung einerseits die Batterie 60 und andererseits die Batteriemanagement-Einheit 66. Diese erfasst kontinuierlich oder quasi-kontinuierlich den Batteriestroms $i_B$ (t) - Messung des Batteriestroms $i_B$ (t); erster Schritt 52 (FIG 4). Dafür umfasst die Batteriemanagement-Einheit 66 eine nicht näher dargestellte, an sich bekannte Sensorik oder ist in geeigneter Weise an eine solche Sensorik angeschlossen, so dass die Aufnahme entsprechender Messwerte möglich ist. Darüber hinaus umfasst die Batteriemanagement-Einheit 66 eine Verarbeitungseinheit 70 in Form von oder nach Art eines Mikroprozessors sowie einen Speicher 72. In den Speicher 72 ist als weiteres Mittel zur Ausführung des Verfahrens ein Computerprogramm 74 geladen, welches Programmcodeanweisungen zur Implementierung des Verfahrens und ggf. einzelner oder mehrerer Ausgestaltungen wie hier beschrieben, speziell zur Implementierung der oben angegebenen Gleichung 4, umfasst.

Im Betrieb der Batteriemanagement-Einheit 66 führt dessen Verarbeitungseinheit 70 das Computerprogramm 74 aus und bewirkt damit eine Realisierung des Verfahrens. Speziell wird eine Alterung A(t) der Batterie 60 ermittelt und entweder ein diesbezüglicher, von einer nachfolgenden Einheit, zum Beispiel einem Fahrerassistenzsystem 68, verarbeitbarer Wert ausgegeben und/oder es erfolgt entsprechend der jeweils ermittelten Alterung A(t) eine Ansteuerung eines Aktors 76, zum Beispiel einer Anzeige in einem Armaturenbrett des Fahrzeugs 62.

Um zum Beispiel Nutzern von Elektro- oder Hybridfahrzeugen 62 einen Anhalt geben zu können, wie sich das jeweilige Fahrverhalten auf die Batteriealterung auswirkt - so führen zum Beispiel hohe Beschleunigungen zu hohen Batterielastströmen und somit zu einer beschleunigten Alterung der Batterie, wird die im Betrieb des Fahrzeugs 62 mit der Batteriemanagement-Einheit 66 aufgrund von Messdaten, nämlich dem Batteriestrom $i_B$ (t), ermittelte Batteriealterung A(t) an das Fahrerassistenzsystem 68 übermittelt. Dieses umfasst üblicherweise selbst eine Verarbeitungseinheit 78 und einen Speicher 80 mit zumindest einem Computerprogramm 82 wie oben beschrieben. Zur Unterscheidung kann das Computerprogramm 74 der Batteriemanagement-Einheit 66 auch als Batteriemanagementcomputerprogramm und das Computerprogramm 82 des Fahrerassistenzsystems 68 als Fahrerassistenzsystemcomputerprogramm 82 bezeichnet werden.

Die Information über die jeweilige Batteriealterung A(t) versetzt das Fahrerassistenzsystem 68 mit einer entsprechenden, in Form des Computerprogramms 82 oder eines Teils des Computerprogramms 82 implementierten Funktionalität in die Lage, dem Fahrzeugführer Vorschläge für ein batterieschonendes Fahrverhalten zu unterbreiten und somit die Batterielebensdauer zu erhöhen und Betriebskosten zu senken. Diese Vorschläge werden dem Fahrzeugführer in Form einer entsprechenden Ansteuerung eines Aktors 84 zur Kenntnis gebracht. Der Aktor 84 kann dabei zum Beispiel ein Anzeigeelement nach Art eine Leuchtdiode oder dergleichen sein, um zum Beispiel durch Farbumschlag auf eine ungünstig hohe Beschleunigung hinzuweisen. Alternativ oder zusätzlich kann der Aktor 84 auch eine Anzeigeeinrichtung sein, die eine Ausgabe von zumindest kurzen Textmeldungen oder dergleichen erlaubt, wie dies von heute in Fahrzeugen gebräuchlichen sogenannten Bordcomputern bekannt ist.

Des Weiteren kann ein Fahrerassistenzsystem 68 auf Basis der berechneten Batteriealterung A(t) und einer entsprechenden Funktionalität im jeweiligen Computerprogramm 82 auch Vorschläge für ein batterieschonendes Fahren des Fahrzeugs 62 und/oder Laden der Batterie 60 unterbreiten. Schließlich kann die Batteriealterung A(t) auch unter Annahme von unterschiedlichen Batterieströmen $i_B$ (t) vorhergesagt und es können auf dieser Grundlage zu erwartende Betriebskosten ermittelt werden.

Solche Vorhersagen und Kostenermittlungen sind in einem alternativen Anwendungsszenario auch für eine Kostenkontrolle einer Benutzung einzelner oder mehrerer Batterien als Energiezwischenspeicher (Energiepuffer) im Rahmen von sogenannten Smart Grid Applikationen anwendbar. Hier kann dann der Einfluss von variierenden Batterieströmen $i_B$ (t) innerhalb eines Ladeteilzyklus (zum Beispiel Laden mit variierendem Ladestrom aus regenerativen Energiequellen) bzw. Entladeteilzyklus (Entladen durch variierende Stromlasten von Verbrauchern) auf die Batteriealterung berücksichtigt und finanziell bewertet werden.

Eine kontinuierliche Überwachung der Batteriealterung in Kombination mit einer Anbindung an eine Cloud Applikation (zum Beispiel per UMTS/LAN) erlaubt zudem eine zentrale Verwaltung und Steuerung von Batterien. Damit können kontinuierlich die verschiedenen Alterungen von Batterieclustern (zum Beispiel in Elektro- oder Hybridfahrzeugflotten oder einer Energiezwischenspeicheranlage) überwacht und deren Nutzung batterieschonend ausgesteuert werden.

Weiterhin kann das hier vorgeschlagene Verfahren dazu genutzt werden, während der Fahrt - also innerhalb eines Teilzyklus - die Batteriealterung kontinuierlich zu bestimmen und zu speichern, um damit eine Fahrtroute bezüglich des Alterungsprozesses der Batterie zu charakterisieren. Zur Erläuterung kann darauf hingewiesen werden, dass eine Fahrtroute zum Beispiel aufgrund vieler Berg- und Talfahrten eine höhere Batteriealterung und damit höhere Betriebskosten verursacht, als eine andere Strecke, bei der solche Belastungen nicht auftreten. Diese Informationen können dann zum Beispiel für eine Fahrzeugnavigationslösung verwendet werden, um eine Routenplanung auch hinsichtlich einer Möglichkeit zur möglichst batterieschonenden Fahrweise zu optimieren. Diese Anwendung ist auch sehr gut für eine Cloud Anbindung geeignet, welche solche Informationen zentral sammelt und dann Elektrofahrzeugen zum Beispiel als Navigationsservice zur Verfügung stellt.

Obwohl die Erfindung im Detail durch das Ausführungsbeispiel näher illustriert und beschrieben wurde, so ist die Erfindung nicht durch das oder die offenbarten Beispiele eingeschränkt und andere Variationen können vom Fachmann hieraus abgeleitet werden, ohne den Schutzumfang der Erfindung zu verlassen.

Einzelne im Vordergrund stehende Aspekte der hier eingereichten Beschreibung lassen sich damit kurz wie folgt zusammenfassen:

Angegeben wird zuvorderst ein Verfahren zur kontinuierlichen Überwachung einer Batteriealterung, bei dem die Batteriealterung auf Basis eines Batteriestroms $i_B$ (t) quantitativ beschrieben wird. Ausgehend von der so ermittelten oder so ermittelbaren Batteriealterung lassen sich zum Beispiel bei Ermittlung einer Batteriealterung einer von einem Elektro- oder Hybridfahrzeug mitgeführten Batterie Hinweise für den Fahrzeugführer zum Alterungszustand der Batterie, aber zum Beispiel auch für eine möglichst batterieschonende Fahrweise ableiten.

**Patentansprüche**

1. Verfahren zur kontinuierlichen Überwachung einer Batteriealterung, wobei die Batteriealterung auf Basis eines Batteriestroms ($i_B$ (t) quantitativ beschrieben wird.

2. Verfahren nach Anspruch 1, wobei zur Beschreibung der Batteriealterung eine von einem jeweiligen Ermittlungszeitpunkt (t) abhängige Alterungszahl (A(t)) ermittelt wird.

3. Verfahren nach Anspruch 2, wobei die jeweils ermittelte Alterungszahl (A(t)) direkt Aufschluss über die Batteriealterung sowie einen eventuell notwendigen Austausch der Batterie gibt.

4. Verfahren nach einem der Ansprüche 1 bis 3, wobei in die Ermittlung der Batteriealterung eine Funktion ($\eta(i_B)$) zur Berücksichtigung des Einflusses der Stromstärke ($i_B(t)$) auf die Batteriealterung einfließt.

5. Verfahren zum Betrieb einer Batteriemanagement-Einheit (66), wobei die Batteriemanagement-Einheit (66) eine Verarbeitungseinheit (70) und einen Speicher (72) umfasst, wobei in den Speicher (72) ein Computerprogramm (74) zur Implementation des Verfahrens nach einem der Ansprüche 1 bis 4 geladen ist, um alle Schritte von jedem beliebigen der Ansprüche 1 bis 4 durchzuführen, wenn das Computerprogramm (74) durch die Verarbeitungseinheit (70) der Batteriemanagement-Einheit (66) ausgeführt wird.

6. Verfahren nach Anspruch 5, wobei die Batteriemanagement-Einheit (66) einem Fahrerassistenzsystem (68) kontinuierlich oder zu vorgegebenen oder vorgebbaren Zeitpunkten Informationen zur Batteriealterung übermittelt.

7. Verfahren nach Anspruch 6, wobei das Fahrerassistenzsystem (68) anhand der zur Batteriealterung erhaltenen Informationen einem Fahrzeugführer die jeweilige Batteriealterung anzeigt, insbesondere zusammen mit Hinweisen im Hinblick auf einen Zusammenhang einer jeweiligen Fahrweise und einer resultierenden Batteriealterung und/ oder mit Hinweisen im Hinblick auf eine batterieschonende Fahrweise.

8. Verfahren nach Anspruch 6 oder 7, wobei das Fahrerassistenzsystem (68) eine Batteriealterung unter Annahme von unterschiedlichen Batterieströmen $i_B$ (t) und auf dieser Grundlage zu erwartende Betriebskosten ermittelt.

9. Computerprogramm mit Programmcode-Mitteln, um alle Schritte von jedem beliebigen der Ansprüche 1 bis 8 durchzuführen, wenn das Computerprogramm durch eine Verarbeitungseinheit (70) einer Batteriemanagement-Einheit (66) ausgeführt wird.

10. Batteriemanagement-Einheit (66) mit einer Verarbeitungseinheit (70) und einem Speicher (72), in den ein Computerprogramm (74) nach Anspruch 9 geladen ist, das im Betrieb der Batteriemanagement-Einheit (66) durch deren Verarbeitungseinheit (70) ausgeführt wird.

FIG 1
(Stand der Technik)

EP 2 631 663 A1

FIG 2
(Stand der Technik)

# FIG 3

## FIG 4

```
┌─────────────────────────────────┐
│ A_ki (D_od) i = [0,1,...M-1]     │ ～ 40
└─────────────────────────────────┘
              │
              ▼
┌─────────────────────────────────┐          ┌─────────────────────────────────┐
│                                 │ ～ 42     │           i_B(t)                │ ～ 52
└─────────────────────────────────┘          └─────────────────────────────────┘
              │                                              │
              ▼                                              ▼
┌─────────────────────────────────┐          ┌─────────────────────────────────┐
│           D_od                  │ ～ 44     │           A (i_B)               │ ～ 54
└─────────────────────────────────┘          └─────────────────────────────────┘
              │                                              │
              ▼                                              ▼
┌─────────────────────────────────┐          ┌─────────────────────────────────┐
│         A_ki (D_od)             │ ～ 46     │           A (t)                 │ ～ 56
└─────────────────────────────────┘          └─────────────────────────────────┘
              │
              ▼
┌─────────────────────────────────┐
│         A (A_ki)                │ ～ 48
└─────────────────────────────────┘
              │
              ▼
┌─────────────────────────────────┐
│           A                     │ ～ 50
└─────────────────────────────────┘
```

Block 40: $A_{ki} (D_{od})\ i = [0,1,...M-1]$

Block 44: $D_{od}$

Block 46: $A_{ki} (D_{od})$

Block 48: $A (A_{ki})$

Block 50: $A$

Block 52: $i_B(t)$

Block 54: $A (i_B)$

Block 56: $A (t)$

FIG 5

# FIG 6

# EP 2 631 663 A1

Europäisches Patentamt
European Patent Office
Office européen des brevets

## EUROPÄISCHER TEILRECHERCHENBERICHT

nach Regel 62a und/oder 63 des Europäischen Patentübereinkommens. Dieser Bericht gilt für das weitere
Verfahren als europäischer Recherchenbericht.

Nummer der Anmeldung

EP 12 15 6563

## EINSCHLÄGIGE DOKUMENTE

| Kategorie | Kennzeichnung des Dokuments mit Angabe, soweit erforderlich der maßgeblichen Teile | Betrifft Anspruch | KLASSIFIKATION DER ANMELDUNG (IPC) |
|---|---|---|---|
| A,D | EP 1 450 173 A2 (DAIMLER CHRYSLER AG [DE] DAIMLER AG [DE]) 25. August 2004 (2004-08-25) * das ganze Dokument * ----- | 1 | INV. G01R31/36 |
| A | DE 10 2010 031337 A1 (SB LIMOTIVE CO LTD [KR]; SB LIMOTIVE GERMANY GMBH [DE]) 19. Januar 2012 (2012-01-19) * Zusammenfassung * * Seite 6, Absatz [0045] - Absatz [0049]; Abbildungen 1, 2 * ----- | 1 | |
| A | US 5 703 469 A (KINOSHITA NAOKI [JP]) 30. Dezember 1997 (1997-12-30) * Zusammenfassung * * Spalte 4, Zeile 18 - Spalte 10, Zeile 13; Abbildungen 1-9 * ----- | 1 | |
| A | DE 103 28 721 A1 (BOSCH GMBH ROBERT [DE]) 13. Januar 2005 (2005-01-13) * Zusammenfassung * * Seite 3, Absatz [0008] - Absatz [0018]; Abbildungen 1, 2 * ----- | 1 | RECHERCHIERTE SACHGEBIETE (IPC) G01R |

## UNVOLLSTÄNDIGE RECHERCHE

Die Recherchenabteilung ist der Auffassung, daß ein oder mehrere Ansprüche, den Vorschriften des EPÜ nicht entspricht bzw. entsprechen, so daß nur eine Teilrecherche (R.62a, 63) durchgeführt wurde.

Vollständig recherchierte Patentansprüche:

Unvollständig recherchierte Patentansprüche:

Nicht recherchierte Patentansprüche:

Grund für die Beschränkung der Recherche:

Siehe Ergänzungsblatt C

| Recherchenort | Abschlußdatum der Recherche | Prüfer |
|---|---|---|
| München | 17. Dezember 2012 | Bergado Colina, J |

EPO FORM 1503 03.82 (P04E09)

Europäisches
Patentamt

European
Patent Office

Office européen
des brevets

**UNVOLLSTÄNDIGE RECHERCHE
ERGÄNZUNGSBLATT C**

Nummer der Anmeldung

EP 12 15 6563

Nicht recherchierte Ansprüche:
     1-10

Grund für die Beschränkung der Recherche:

Der vorliegende Anspruch 1 bezieht sich auf eine extrem große Zahl möglicher Verfahren. Stützung und Offenbarung im Sinne der Artikel 84 und 83 EPÜ lassen sich jedoch nur für einen sehr kleinen Teil der beanspruchten Verfahren finden, siehe Seite 6, Zeile 6 bis Seite 7, Zeile 8 der Beschreibung.
Ferner bezieht sich der vorliegende Anspruch 1 auf ein Verfahren mit lediglich einer bestimmten gewünschten Eigenschaft oder Wirkung, nämlich auf das Benötigen eines Verfahrens zur kontinuierlichen Überwachung einer Batteriealterung, wobei die Batteriealterung auf Basis eines Batteriestroms quantitativ beschrieben wird (siehe Seite 1, Zeilen 33-35, wo die allgemeine Aufgabe der Erfindung angegeben wird).
Außerdem wurde in der Anfangsphase der Recherche eine sehr große Zahl von Dokumenten gefunden, die für die Neuheitsfrage von Bedeutung sind. Es wurden so viele Dokumente gefunden, dass es unmöglich ist zu bestimmen, welche Teile des Anspruchs 1 den Gegenstand definieren, für den ein Schutzanspruch gerechtfertigt wäre (Artikel 84 EPÜ). Aus diesen Gründen konnte keine sinnvolle Recherche für den gesamten beanspruchten Gegenstand des Anspruchs 1 durchgeführt werden (Regel 63 EPÜ).
Der Gegenstand der abhängigen Ansprüchen 2 bis 10 besteht lediglich aus sehr verallgemeinert, bekannten Merkmalen, die ebenfalls als Objekt einer sinnvollen Recherche keinesfalls in Frage kommen können (Regel 63 EPÜ).
Die Verletzung der einschlägigen Erfordernisse ist daher so schwerwiegend, dass eine sinnvolle Recherche für den beanspruchten Gegenstand als Ganzes nicht durchgeführt werden kann (Regel 63 EPÜ und Richtlinien B-VIII, 3).
Die Recherche des Anspruchs 1 war somit auf den einzigen Gegenstand, der Stützung in der Beschreibung finden könnte, beschränkt, nämlich auf das Beispiel, das auf Figur 4, rechte Seite, in Zusammenhang mit Seite 13, Zeilen 1-9 und Seite 6, Zeile 6 bis Seite 7, Seite 14 zu finden ist.

**EP 2 631 663 A1**

ANHANG ZUM EUROPÄISCHEN RECHERCHENBERICHT
ÜBER DIE EUROPÄISCHE PATENTANMELDUNG NR.

EP 12 15 6563

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

17-12-2012

| Im Recherchenbericht angeführtes Patentdokument | Datum der Veröffentlichung | Mitglied(er) der Patentfamilie | Datum der Veröffentlichung |
|---|---|---|---|
| EP 1450173 A2 | 25-08-2004 | EP 1450173 A2<br>JP 2004264303 A<br>US 2005001625 A1 | 25-08-2004<br>24-09-2004<br>06-01-2005 |
| DE 102010031337 A1 | 19-01-2012 | DE 102010031337 A1<br>WO 2012007206 A1 | 19-01-2012<br>19-01-2012 |
| US 5703469 A | 30-12-1997 | JP 3540437 B2<br>JP 8336202 A<br>US 5703469 A | 07-07-2004<br>17-12-1996<br>30-12-1997 |
| DE 10328721 A1 | 13-01-2005 | CN 1813199 A<br>DE 10328721 A1<br>EP 1642146 A2<br>US 2006250137 A1<br>WO 2005003799 A2 | 02-08-2006<br>13-01-2005<br>05-04-2006<br>09-11-2006<br>13-01-2005 |

EPO FORM P0461

Für nähere Einzelheiten zu diesem Anhang : siehe Amtsblatt des Europäischen Patentamts, Nr.12/82

17

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1450173 A

- EP 1450173 A2

**In der Beschreibung aufgeführte Nicht-Patentliteratur**

- *Working Paper Sustainability and Innovation No. S4/2010,* 12-13